Europäisches Patentamt

(19) European Patent Office

Office européen des brevets

(11) Publication number: **0 019 119**
A2

(12) # EUROPEAN PATENT APPLICATION

(21) Application number: **80102234.4**

(22) Date of filing: **25.04.80**

(51) Int. Cl.³: **H 01 L 21/265**
**H 01 L 21/00, H 01 L 29/78**

(30) Priority: **21.05.79 US 41023**

(43) Date of publication of application:
**26.11.80 Bulletin 80 24**

(84) Designated Contracting States:
**DE FR GB**

(71) Applicant: **International Business Machines Corporation**

**Armonk, N.Y. 10504(US)**

(72) Inventor: **Jambotkar, Chakrapani Gajanan**
**154 Hosner Mountain Road**
**Hopewell Junction New York 12533(US)**

(72) Inventor: **Wang, Paul Por-yuan**
**RD2, No.9, City View Terrace**
**Kingston New York 12401(US)**

(74) Representative: **Richards, John Peter**
**IBM UNITED KINGDOM PATENT OPERATIONS Hursley Park**
**Winchester Hants SO21 2JN(GB)**

(54) Method of forming a short-channel field-effect transistor and field-effect transistor made by that method.

(57) A field effect transistor (FET) with a very small effective channel length is made by using a first ion implantation to produce the source (18) and drain (19) regions of the FET and a second very shallow ion implantation (22) next to the source region (18) to produce the effective short channel of the FET. The effective channel of the FET is implanted to only a small fraction of the depth of the source and drain. This permits superior control over the threshold voltage of the FET and increases the operating speed of the FET.

FIG. 5

EP 0 019 119 A2

- 1 -

METHOD OF FORMING A FIELD EFFECT TRANSISTOR

This invention relates to a method of forming a field effect transistor.

It is well known in the art that the frequency response or switching speed of an IGFET improves as the channel length and parasitic capacitances of the IGFET are reduced in magnitude. The reason for this is that a reduction in channel length reduces the transit time for carriers travelling between source and drain, while a reduction in the parasitic capacitances decreases the time required for charging and discharging the capacitances. Double-diffused metal oxide semiconductors (D/MOS), such as the one described in Cunningham et al U. S. Patent 3,996,655, are short-channel IGFETs with reduced parasitic capacitances. In a typical N- channel D/MOS type device, a substrate with very low π type impurity concentration has source and drain regions having an N+ type impurity diffused therein in the typical MOS fashion. What is distinguishing about the D/MOS construction is that the N+ source region is set within a larger and deeper diffusion of P- impurity which effectively provides a narrow P- type channel adjacent to the source, while the π type region between the P- type diffusion and the N+ type drain diffusion functions as a drift region.

With this D/MOS construction, very short channel lengths are realizable by properly controlling the N+ and P- diffusions in and around the source region. Furthermore, in a D/MOS the parasitic drain-to-substrate capacitance is smaller than a conventional short-channel MOS device, because the N+ drain diffusion of the D/MOS is surrounded by the substrate having a very low $\pi$ type impurity. However, the P-channel diffusion around the source diffusion still maintains a substantial capacitance at the periphery of the source region just as in a conventional FET. Furthermore, for reasons that will be discussed later in the description, the threshold voltage of a D/MOS varies considerably from unit to unit.

According to the invention there is provided a method for forming a short-channel field effect transistor of the kind comprising source and drain regions spaced apart in the surface of a semiconductor substrate and an effective channel region in the surface of the substrate adjacent the source region and spaced from the drain region, the method being characterised by:

a) ion-implanting an impurity of one conductivity type to a first depth into the surface of a low conductivity substrate of opposite conductivity type to form two spaced regions of the said one conductivity type to function as the source and drain respectively of the field effect transistor;

b) ion implanting an impurity of the opposite conductivity type to a second depth into the substrate surface over an area including at least a portion of a first of the said two spaced regions and a portion of the substrate surface between the two regions, the second depth being only a small fraction of the first depth, to form a third region of the said opposite conductivity type adjacent to the first of the two spaced regions but spaced from the second of the two regions to function as the effective channel of the field effect transistor;

c) forming a gate for the field effect transistor insulated from the substrate over the third region; and

d) forming electrical contacts to the two spaced regions and to the gate to provide connections to the field effect transistor.

The use of implantation steps in the above-defined manner in combination with the use of a shallow effective channel in the FET permits superior manufacturing control over the threshold voltage and significantly reduces the stray capacitances.

A further problem with the prior art D/MOS devices is that it is very difficult to achieve a consistently accurate length for the effective channel, particularly at sub-micron dimensions, due to the inadequate control which can be exercised in the diffusion technique. This is only partially overcome by ion-implantation, since while the uncertainties of diffusion are removed, conventional ion-implantation techniques are still subject, like diffusion techniques, to error in mask dimensions and mask alignment. This problem is solved, or at least substantially mitigated, in the preferred embodiment of the present invention by using an oxidised polysilicon region for masking against the source and drain implantations, and then using the same region without the oxide for masking against the channel diffusion.

Embodiments of the invention will now be described, by way of example, with reference to the accompanying drawings, wherein:

Figure 1 is a circuit diagram of two FET transistors connected in series;

- 4 -

Figure 2 is a sectional view of a fragment of a semiconductor substrate containing the circuit of Figure 1 where one of the devices is a prior art D/MOS transistor;

Figure 3 is an impurity concentration profile for the structure of Figure 2;

Figure 4 is a plan view of a fragment of a semiconductor substrate containing the circuit of Figure 1 wherein the one of the transistors is a short-channel FET made in accordance with an embodiment the present invention;

Figure 5 is a section along line 5-5 in Figure 4;

Figure 6 is an impurity concentration profile for the structure of Figures 4 and 5;

Figures 7 to 16 are sectional views illustrating successive processing steps of the FET of Figures 4 and 5; and

Figures 17 and 18 are sectional views illustrating alternative processing steps for the FET.

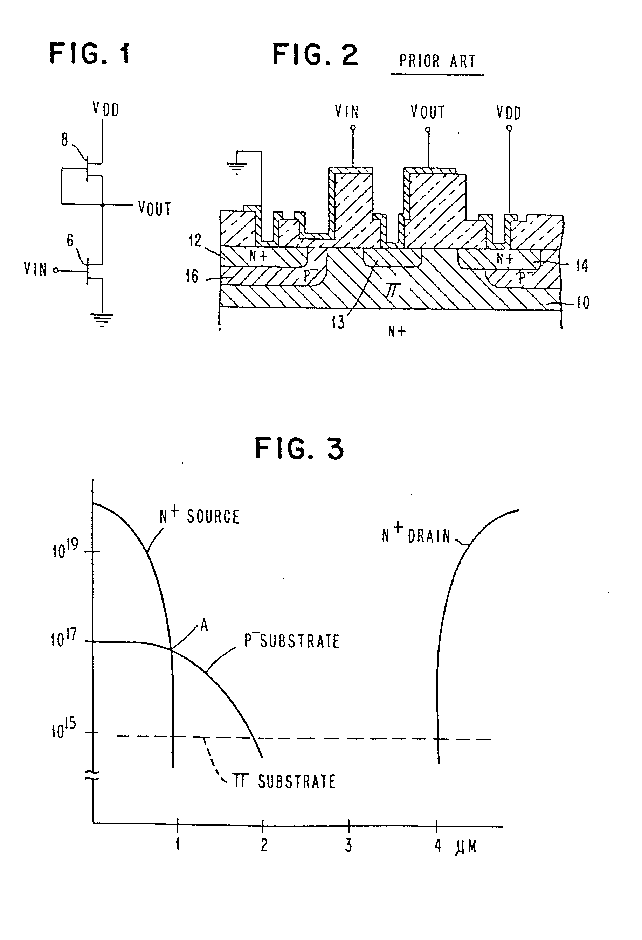

Figure 1 shows an enhancement mode FET 6 connected to a depletion mode FET 8 in series between an electrical potential of excitation $V_{DD}$ and ground. Figure 2 is a cross section of a semiconductor substrate containing that circuit produced in accordance with the previously mentioned U.S. Patent 3,996,655. As shown, the circuit is formed by a substrate 10 of π material which has N+ source and drain diffusions 12, 13 and 14, for the two devices therein. Surrounding the source diffusion for the enhancement mode D/MOS type device there is a P- diffusion 16 which provides the effective channel of that device.

- 5 -

Figure 3 is an impurity concentration profile for the enhancement mode D/MOS type FET of Figure 2 in which the distance along the silicon surface from the source opening edge toward the drain opening edge of the FET is plotted on the x-axis, while the impurity concentration of the device is plotted on the y-axis. The threshold voltage, $V_{TE}$, of the D/MOS FET in Figure 2 is determined by the P- impurity concentration at the intersection point A of the N+ and P- diffusions. With state-of-the-art diffusion processes, it is difficult to control the magnitude of the P- impurity concentration at the intersection point A because the concentration profiles of impurities for both the N+ and P-diffusions vary from time to time.

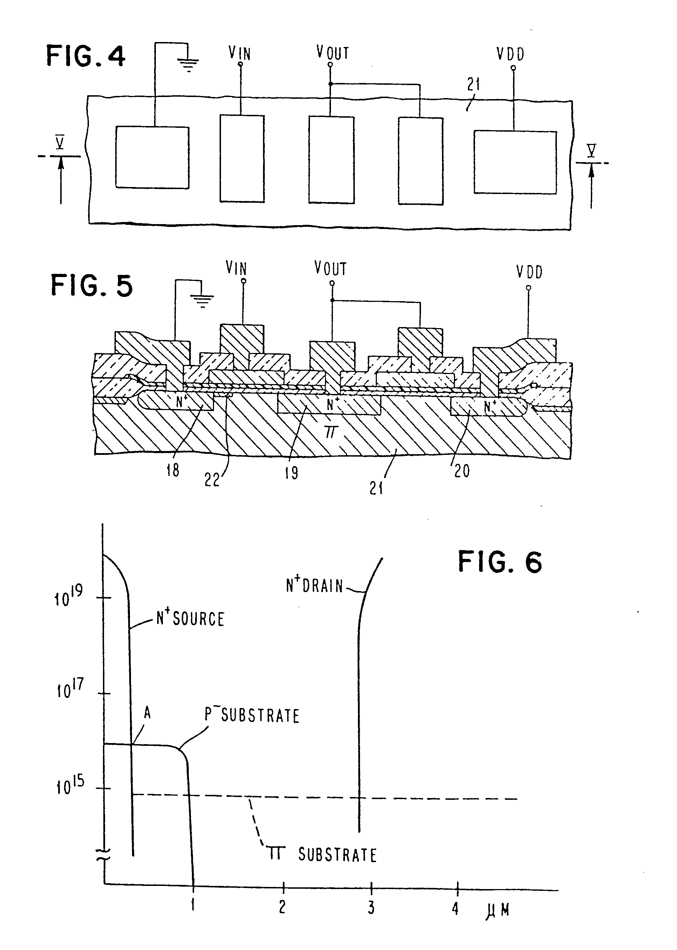

In accordance with an embodiment of the present invention, enhancement FET's with short channels are realized without resorting to the use of a multiple-step diffusion in the source region to generate the short channel. As shown in Figures 4 and 5, the N+ source and drain regions 18, 19 and 20 are ion-implanted in a π substrate 21 during one process step and then, in a later process step, the P- channel region 22 is ion-implanted in a region adjacent to the source region of the enhancement FET. The concentration profile of this short-channel FET is shown in Figure 6. As can be seen, the concentration of the P- region 22 is uniform along the silicon surface, in particular at and around the intersection point A, so that the P- concentration at the point A, and thus the threshold voltage of the device, is well defined.   This is because the state-of-the-art of ion implantation permits a very precise control over the concentration of impurities introduced in a substrate. Further, the process sequence described below, is specifically arranged to avoid any high-temperature heat cycles subsequent to the ion implantation so that the concentration profiles of the impurities remain practically invariant after implantation. As a consequence, the threshold voltage $V_{TE}$ of the enhancement FET remains substantially invariant from unit to unit. Also, the use of ion implantation steps instead of diffusion steps allows greater control over the effective channel length. Furthermore, as a result of the P-channel implantation being confined to only a small fraction of the depth of the source region, preferably between 0.03 and 0.25 of the depth of the source region, the source-to-substrate capacitance is reduced to substantially the same extent as the drain-to-substrate capacitance.

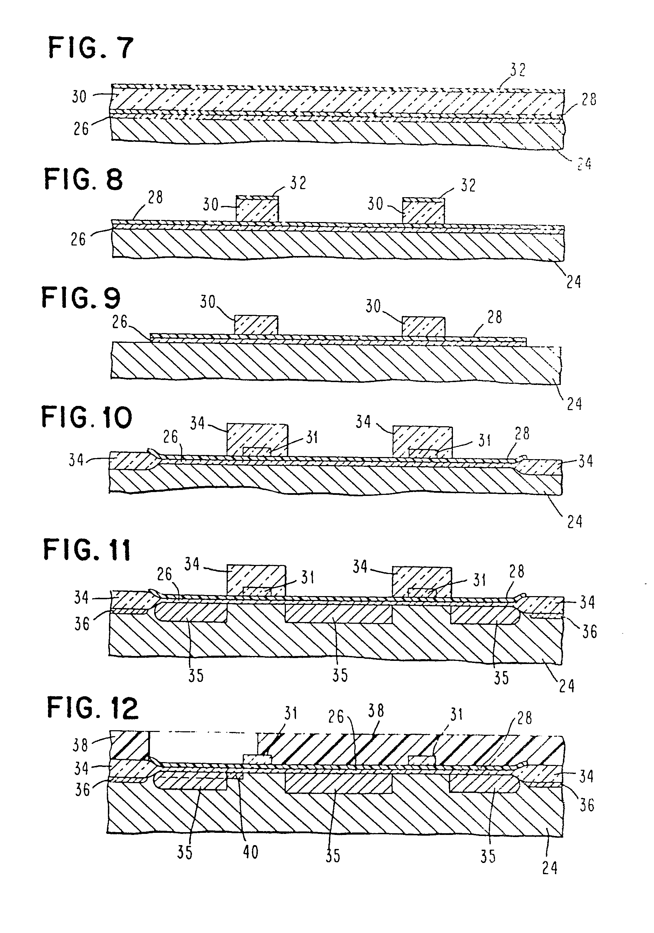

Figures 7 to 16 illustrate successive process steps by which the structure of Figure 4 and 5 can be fabricated. It is to be understood that the fragment of substrate shown in Figure 7 to 16 is part only of a much larger substrate in which similar pairs of FETs are produced sumultaneously by the same process steps.

Figure 7 shows a low conductivity $\pi$ type silicon substrate 24 with a resistivity typically of 20-100 ohm-cm. Grown on this substrate is an approximately 300 Å thick thermal $SiO_2$ layer 26 and successively deposited on the $SiO_2$ layer 26 are a layer 28 of $Si_3N_4$, a layer 30 of polysilicon and a layer 32 of pyrolitic $SiO_2$ having typical thicknesses of 300 Å, 8500 KÅ and 1000KÅ respectively.

As shown in Figure 8, conventional photolithography is used to selectively etch the pyro $SiO_2$ and polysilicon layers 32 and 30. Thereafter, as shown in Figure 9, the remnant $SiO_2$ layer 32 is removed by dip-etching and then the $Si_3N_4$ layer 28 and the $SiO_2$ layer 26 are photolithographically masked and selectively etched, preferably using reactive ion etching. This leaves a rectangular portion of the substrate 24 still covered with the

$Si_3N_4$ and $SiO_2$ layers, and that rectangular portion itself partially covered by two stripes of polysilicon 30.

As illustrated in Figure 10, a thermal $SiO_2$ layer 34 is grown over the exposed surface of the substrate 24 and also on the top and side surfaces of the polysilicon layer 30 oxidizing a portion of the polysilicon layer in the process. The unoxidized portion of the original polysilicon layer 30 is identified as 31 in Figure 10. $SiO_2$ 34 does not grow over the exposed $Si_3N_4$ layer 28 except where growth on the sidewalls of the polysilicon layer 31 overlies the exposed surface of $Si_3N_4$ layer 28. The thickness of the $SiO_2$ layer 34 on the top and side walls of the polysilicon 31 is designed to be equal to the desired effective channel length of the enhancement FET, one micrometer being a typical value.

Using $SiO_2$ layer 34 as a mask, an N+ type impurity, such as phosphorus, is then ion-implanted into the substrate to a junction depth of about 0.7µ to form the source and drain regions 35 for the enhancement and depletion mode FET's as shown in Figure 11. Typical suitable doses and energies for two succesive implantations of phosphorus are (a) $3 \times 10^{15}$ ions/cm$^2$ at 400 kev and (b) $5 \times 10^{15}$ ions/cm$^2$ at 150 kev. The magnitude of the junction depth of source and drain added to the magnitudes of thicknesses of $SiO_2$ layer 26 and $Si_3N_4$ layer 28 is, by design, less than the thickness of $SiO_2$ layer 34.

A layer of developed photoresist in conjunction with ion implantation is now used to form a skin layer 36 of a P- type impurity such as boron to form channel stopper regions. The typical suitable dose and energy for the boron in the channel stopper region are $8 \times 10^{11}$ ions/cm$^2$ and 400 kev, respectively. After completion of the channel-stopper ion implantation step, developed photoresist is used to cover $SiO_2$ in the "field" region

- 8 -

and the $SiO_2$ 34 covering the polysilicon 31 is etched away. The
photoresist is stripped and a new layer 38 (Fig. 12) of developed
photoresist is used to cover all areas excepting the short-
channel region and a portion of the source region of the enhancement
FET in the immediate vicinity of the channel regions. Ion implantation is now used to deposit a skin layer 40 of a P-type impurity,
such as boron, in the substrate. The typical suitable dose and
energy for implant of boron in this "effective" channel region of
the enhancement FET are 6 x $10^{10}$ ions/$cm^2$ and 20 kev, respectively.
The P- type impurity, introduced in the heavily doped N+ source
region of the enhancement FET gets overcompensated.

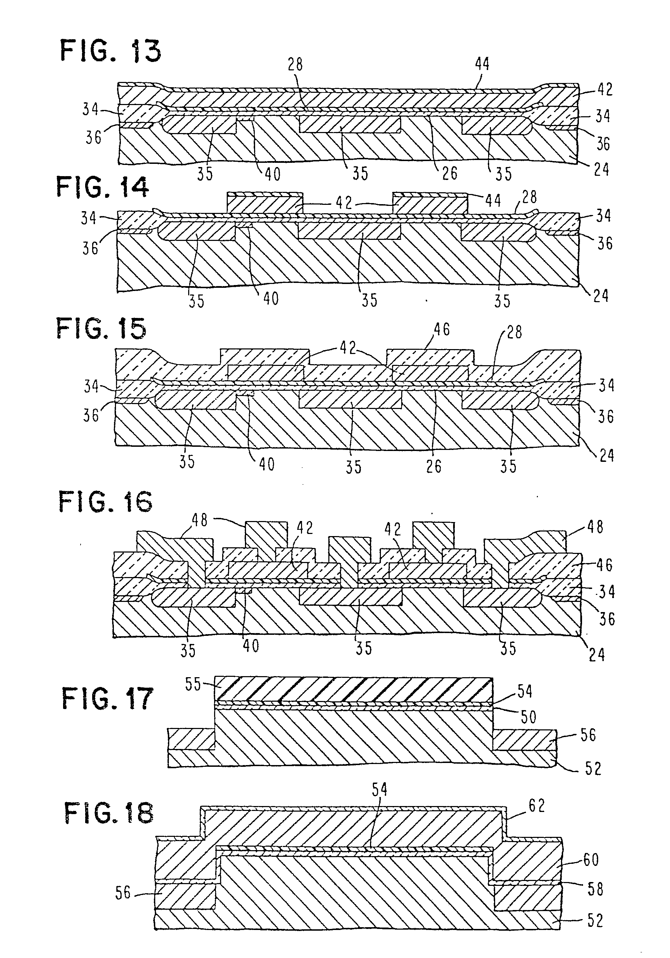

As shown in Fig. 13, the remnant polysilicon layer 31 is
removed by dip-etching and new layers of N+ doped polysilicon 42
and pyrolytic $SiO_2$ layer 44 are deposited over the whole surface.
Thicknesses of the layers 42 and 44 are approximately 8000 Å and
1000 Å respectively. If desired, the remnant silicon nitride
layer 28 can be removed by dip-etching prior to deposition of
layers 42 and 44.

The newly deposited layers 42 and 44 are then selectively
etched as shown in Figure 14 to define the conductive polysilicon
gates for the enhancement and depletion FET's and thereafter an
approximately 5000 Å thick layer 46 of pyrolytic $SiO_2$ is deposited
over the whole surface as illustrated in Figure 15.

Thereafter, photolithography is used to selectively etch
regions for metal contacts to the polysilicon gates 42 and the
source and drain regions 35. A metal 48 such as aluminum, about
one micrometer in thickness, is deposited and interconnection
patterns are formed in the metal film through photolithography,
see Figure 16. After annealing the metal, the substrate processing
can be finished using standard procedures of passivation, chip
dicing, etc.

- 9 -

With the described procedure, the effective channel length
of the enhancement FET's is equal to the thickness of the thermal
$SiO_2$ 34 grown on the sidewalls of the polysilicon 31.  This is
because once the channel impurities have been implanted, there is
virtually no diffusion movement of the impurities as a result of
all ensuing heating cycles being at a low temperature of at most
800° - 850° C.  With the current state-of-the-art, the thickness
of the thermal $SiO_2$ layer 34 on the sidewalls of the polysilicon
31, and hence the effective channel length of the enhancement
FET, can be readily controlled with great precision at micron or
submicron values.  This precision is not readily attainable using
diffusion techniques as in the prior art, nor by ion-implantation
using conventional marketing techniques.

The following process is identical to the one described
above except that the field $SiO_2$ is fully recessed rather than
partially recessed and that the need for photolithography in the
process steps providing the channel-stopping regions is eliminated.
As shown in Figure 17, an approximately 300 Å thick layer 50 of
thermal $SiO_2$ is grown on a π type silicon substrate 52 of about
20-100 ohm-cm resistivity.  Thereafter, a 300 Å layer 54 of
$Si_3N_4$ is deposited on the $SiO_2$ layer.  Photoresist 55 is deposited
and developed using a mask.  Reactive ion etching is then used to
etch $Si_3N_4$ layer 54, the $SiO_2$ layer 50 and the exposed silicon 52
to a depth of about 5500 Å in the exposed regions. With the
photoresist still in place, ion implantation is used to deposit a
P- type impurity such as boron in the exposed silicon.  The
implant dose and energy are chosen so as to realize, at the end
of all wafer processing, a P-type "channel-stopping" region 56
with a typical concentration of $3 \times 10^{16}$ a/cc at the interface of
the field $SiO_2$ and silicon substrate.

The photoresist 55 is then removed and 500 $\overset{o}{A}$ thick layer 58 of $SiO_2$ is formed on the exposed silicon as shown in Figure 18. Thereafter, an approximately 8.5 K$\overset{o}{A}$ thick polysilicon layer 60 and an approximately 1 K$\overset{o}{A}$ thick pyrolytic $SiO_2$ layer 62 are deposited. The remainder of the processing is the same as described previously in connection with Figures 8 to 16 with the exception of the elimination of the steps concerning the channel-stopping region.

- 11 -

CLAIMS

1.      A method for forming a short-channel field effect
transistor of the kind comprising source and drain regions spaced
apart in the surface of a semiconductor substrate and an effective
channel region in the surface of the substrate adjacent the
source region and spaced from the drain region, the method being
characterised by:

        a)   ion-implanting an impurity of one conductivity type
to a first depth into the surface of a low conductivity substrate
of opposite conductivity type to form two spaced regions of the
said one conductivity type to function as the source and drain
respectively of the field effect transistor;

        b)   ion implanting an impurity of the opposite conductivity
type to a second depth into the substrate surface over an area
including at least a portion of a first of the said two spaced
regions and a portion of the substrate surface between the two
regions, the second depth being only a small fraction of the
first depth, to form a third region of the said opposite conductivity type adjacent to the first of the two spaced regions but
spaced from the second of the two regions to function as the
effective channel of the field effect transistor;

        c)   forming a gate for the field effect transistor
insulated from the substrate over the third region; and

        d)   forming electrical contacts to the two spaced
regions and to the gate to provide connections to the field
effect transistor.

2.      The method of forming a field effect transistor of
Claim 1, wherein the gate is a silicon gate.

3.      The method of forming a field effect transistor of
Claim 1 or 2, wherein the second depth is between 0.03 and 0.25
of the first depth.

4.      The method of forming a field effect transistor of
Claim 1, 2 or 3, wherein the substrate is π material, the two
spaced regions are of N+ type conductivity, and the third region
is of P- type conductivity.

5.      The method of forming a field effect transistor of any
preceding claim, including maintaining all processing steps below
850°C after the ion implantation steps.

6.      The method of any preceding claim, wherein the ion
implantation of the opposite conductivity type is performed after
the ion implantation of the one conductivity type.

7.      The method of Claim 6, wherein the formation of the two
spaced regions of the one conductivity type is accomplished by
providing a polysilicon region over the substrate surface between
the desired locations of the two spaced regions, thermally
growing an $SiO_2$ layer on the substrate surface and on the polysilicon region including the sides thereof, the $SiO_2$ layer having
openings coincident with the desired locations of the two spaced
regions, the edges of the openings facing one another being
defined by the $SiO_2$ layer on opposite sides respectively of the
polysilicon region, and forming the two spaced regions by ion-
implantation into the substrate surface using the $SiO_2$ layer as a
mask whereby the spacing between the source and drain regions is substantially equal to the width of the oxidised polycrystalline region in the direction between the said opposite sides thereof, and wherein the formation of the third region of the opposite conductivity type is accomplished by removing the thermally grown layer from the unoxidized portion of the polysilicon region, and forming the third region by ion-implantation using the unoxidised portion of the polysilicon region as at least a portion of a mask for the ion-implantation whereby the effective channel length is substantially equal to the thickness of the $SiO_2$ layer originally on the sides of the polysilicon region.

8.    A field effect transistor made by the method of any preceding claim.

## FIG. 1

## FIG. 2  PRIOR ART

## FIG. 3

**FIG. 4**

**FIG. 5**

18  22  19  21  20

**FIG. 6**

FIG. 7

FIG. 8

FIG. 9

FIG. 10

FIG. 11

FIG. 12

**FIG. 13**

**FIG. 14**

**FIG. 15**

**FIG. 16**

**FIG. 17**

**FIG. 18**